(19) Europäisches Patentamt

European Patent Office

Office européen des brevets

(11) EP 1 359 668 A1

(12) **EUROPEAN PATENT APPLICATION**

(43) Date of publication:
05.11.2003 Bulletin 2003/45

(51) Int Cl.⁷: **H03K 17/16**, H04L 25/02

(21) Application number: 03008573.2

(22) Date of filing: 14.04.2003

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **15.04.2002 JP 2002111939**

(71) Applicant: **NEC Electronics Corporation Kawasaki, Kanagawa 211-8668 (JP)**

(72) Inventor: **Fukui, Tadashi, NEC Electronics Corporation Kawasaki, Kanagawa 211-8668 (JP)**

(74) Representative: **Glawe. Delfs. Moll Patentanwälte Postfach 26 01 62 80058 München (DE)**

(54) **Output buffer circuit**

(57)      An output buffer circuit includes a delay circuit (12) for delaying data signal or an inverted version of the data signal by a preset time, a buffer (13) for buffering the data signal with an output impedance of a higher value to output the resulting buffered signal, and a three-state buffer (14), which is controlled responsive to the output of the delay circuit (12) and to the data signal, so that the three-state buffer (14) is activated within the preset time to buffer the data signal and to output the buffered data signal, and is de-activated and turned off outside the preset time.

FIG . 1

1; OUTPUT BUFFER CIRCUIT

EP 1 359 668 A1

## Description

FIELD OF THE INVENTION

This invention relates to an output buffer circuit and, more particularly, to an output buffer circuit which applies pre-emphasis distortion to a logic amplitude of a data signal to transmit and output the resulting data signal to a transmission line.

BACKGROUND OF THE INVENTION

Recently, with the increasing operating speed of the LSIs, such as memories or processors, a data signal which is input and output between the LSIs or devices is increasing in frequency, such that it has become necessary to deem an interconnection between the LSIs or devices as a transmission line to expedite the output/input or transmission/reception of the data signal.

As one of the measures for speedup, the transmission line is terminated by a terminal resistance, at a receiving input unit from the transmission line, to prevent reflection of the data signal caused by impedance missmatching at the receiving input unit, as well as to prevent garbled coding of a data signal ascribable to the reflection of the data signal.

As further measures for speedup, it has been proposed in for example the Japanese Patent Kokai Publication JP-P2000-68816A to match the output impedance of an output buffer circuit, transmitting and outputting a data signal, to the characteristic impedance of the transmission line, at a transmission output to the transmission line, to prevent multiple reflection ascribable to re-reflection of the reflection signal, and also to apply pre-emphasis distortion to the logic amplitude by the output buffer circuit for a certain time during transition of the data signal to generate a transmission signal of the multi-level waveform to output the so generated transmission signal to the transmission line, in consideration that the higher the frequency of the high frequency components of the data signal, the larger the loss incurred in the transmission line, with the received signal waveform at the receiving input unit becoming correspondingly dull.

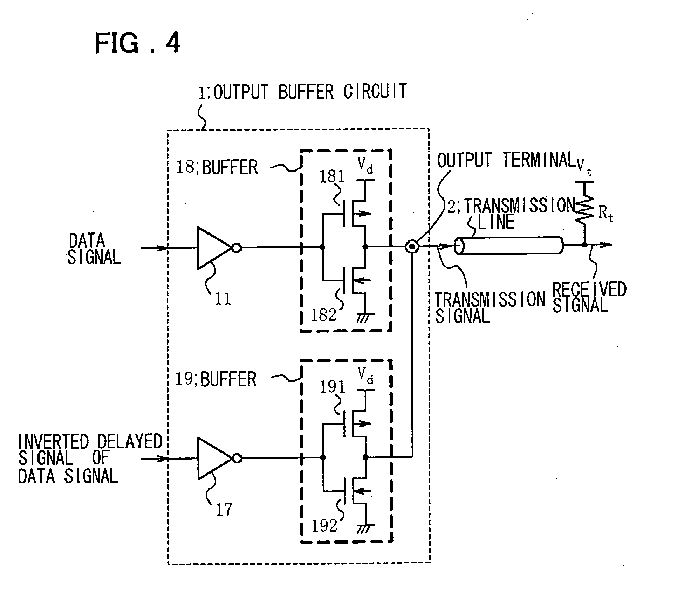

Fig.4 is a circuit diagram showing an illustrative configuration of this conventional output buffer circuit. Specifically, this circuit configuration shows the simplest typical circuit shown in the specification of the Japanese Patent Application 2000-280559, as now pending, filed in the name of the present Assignee (Japanese Patent Kokai Publication JP-P2002-094365A).

Referring to Fig.4, this conventional output buffer circuit 1 includes an inverter 11, an inverter 17, a buffer 18 and a buffer 19, operating on being supplied with a power supply voltage Vd, and drives a transmission end of a transmission line 2, connected to an output terminal, to output a transmission signal. The receiving end of the transmission line 2 is terminated by a terminal resistor Rt and a terminal voltage Vt, and is matched to the characteristic impedance of the transmission line 2.

The inverter 11 receives a data signal which is supplied from outside and inverts the signal to output the inverted signal. Meanwhile, the data signal, supplied to the inverter 11, is generated in the outside, and not shown in Fig.4, in synchronism with a clock signal.

The inverter 17 is supplied from the outside with an inverted delayed signal obtained on inverting and delaying the data signal to output a delayed signal of the data signal. It is noted that the inverted delayed signal, supplied from outside to the inverter 17, is a signal obtained on delaying the data signal by a preset time duration corresponding to one clock period and on complementing the resulting signal. In the present conventional case, the inverted delayed signal is obtained in the outside, not shown in Fig.4, by a delay circuit operating in synchronism with the clock signal and an inverter.

The buffer 18 receives the inverted signal of the data signal output from the inverter 11, and buffers the signal to output the resultant signal to an output terminal. The buffer 18 is provided with a P-type output stage transistor 181 and an N-type output stage transistor 182, performing a complementary operation. The P-type output stage transistor 181 and the N-type output stage transistor 182 have approximately equal on-resistances Ra, such that the output resistance of the buffer 18 is equivalent to the on-resistance Ra both at the time of outputting the high level and at the time of outputting the low level.

The buffer 19 is connected to the output terminal in parallel with the buffer 18 and receives the delayed signal of the data signal to buffer the data signal to output the resultant data signal to the output terminal. This buffer 19 is provided with a P-type output stage transistor 191 and the N-type output stage transistor 192, having approximately equal on-resistances Rb, which are set to, for example, a value equal to twice the output resistance Ra of the buffer 18.

An output impedance Zout of the output buffer circuit 1, comprised of a parallel connection of the buffers 18 and 19, as seen from the output terminal, is equal to the combined parallel resistance of the output buffers 18 and 19, and equivalent to the combined parallel resistance of the on-resistances Ra and Rb, that is Ra*Rb/(Ra + Rb), with the output impedance Zout being approximately constant and matched to the characteristic impedance of the transmission line 2.

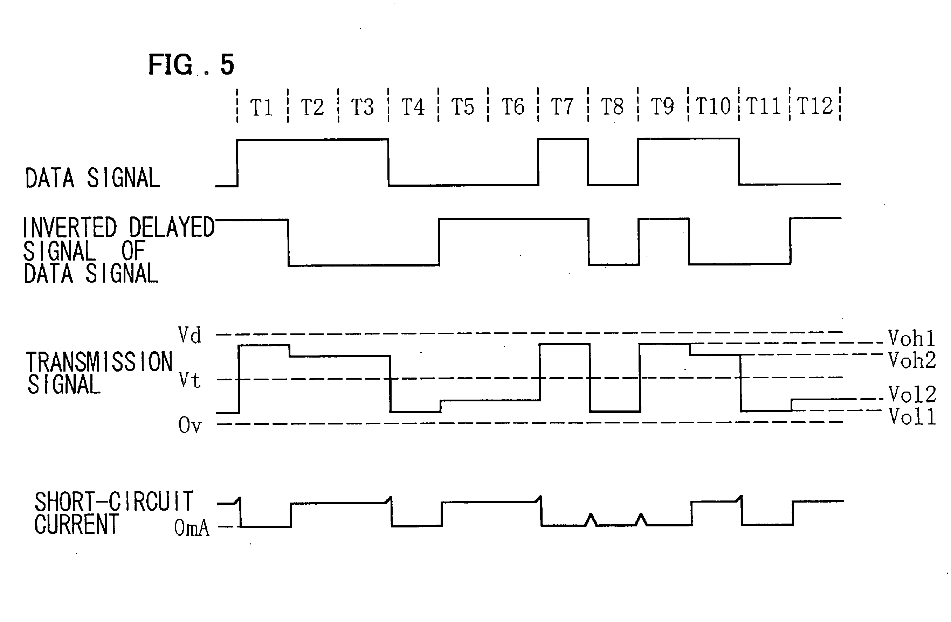

Fig.5 is a timing chart showing an illustrative operation of this conventional output buffer circuit 1. Referring to Figs.4 and 5, the operation of this conventional output buffer circuit 1 is explained.

First, at a timing T1, the data signal undergoes a transition from a low level to a high level, an inverted delayed signal of the data signal is at a high level, and the P-type output stage transistors 181 and 191 of the buffers 18 and 19 are turned on, with the other output stage transistors being in the off-state. Thus, the circuit configuration is such that the power supply voltage Vd and the terminal voltage Vt are applied to the output terminal via on-resistances Ra and Rb of the P-type output stage transistors 181 and 191 and the terminal resistance Rt, with the transmission signal level at the output terminal being, by Kirchhoff's law, the following high level output voltage Voh1 (the high level output voltage subjected to pre-emphasis):

$$Voh1 = Vt + (Vd-Vt)(Rb+Ra)Rt/(RaRb+RaRt+RtRb).$$

At timings T2 and T3, the data signal and the inverted delayed signal are at the high level and at the low level, respectively, and the P-type output stage transistor 181 and the N-type output stage transistor 192 of the buffers 18 and 19 are turned on, with the other output stage transistors being in the off-state. Thus, the circuit configuration is such that the power supply voltage Vd, grounding voltage 0V and the terminal voltage Vt are applied to the output terminal via on-resistances Ra and Rb of the P-type output stage transistor 181 and the N-type output stage transistor 192, and via the terminal resistance Rt, with the transmission signal level at the output terminal being, by Kirchhoff's law, the following high level output voltage Voh2 (the high level output voltage subjected to de-emphasis):

$$Voh2 = Vt + \{(Vd-Vt)Rb-VtRa)Rt/(RaRb+RaRt+RtRb).$$

At a timing T4, the data signal transfers to a low level, the inverted delayed signal is at a low level, and the N-type output stage transistors 182 and 192 of the buffers 18 and 19 are turned on, with the other output stage transistors being off. Thus, the circuit configuration is such that the grounding voltage 0V and the terminal voltage Vt are applied to the output terminal through the on-resistances Ra and Rb of the N-type output stage transistors 182 and 192 and the terminal resistance Rt, so that the transmission signal level at the output terminal is, by Kirchhoff's law, the following low level output voltage Vol1 (the low level output voltage subjected to pre-emphasis):

$$Vol1 = Vt-Vt(Ra+Rb)Rt/(RaRb+RaRt+RtRb).$$

At timings T5 and T6, the data signal and the inverted delayed signal are at low and high levels, respectively, and the N-type output stage transistor 182 and the P-type output stage transistor 191 of the buffers 18 and 19 are turned on, with the other output stage transistors being off. Thus, the circuit configuration is such that the ground voltage 0V, power supply voltage Vd and the terminal voltage Vt are applied to the output terminal through the on-resistances Ra and Rb of the N-type output stage transistor 182 and the P-type output stage transistor 191. Thus, the circuit state is such that the transmission signal level at the output terminal is, by Kirchhoff's law, the following high level output voltage Vol2(the low level output voltage subjected to de-emphasis):

$$Vol2 = Vt-\{VtRb-(Vd-Vt)Ra\}Rt/\{RaRb+Rt(Ra+Rb)\}.$$

In similar manner, at timing T7, as at the timing T1, the transmission signal level at the output terminal is the high level output voltage Voh1. At timing T8, as at a timing T4, the transmission signal level at the output terminal is the low level output voltage Vol1. At a timing T9, as at the timings T1 and T7, the transmission signal level at the output terminal is the high level output voltage Voh1. At timing T10, as at the timing T2, the transmission signal level at the output terminal is the high level output voltage Voh2. At a timing T11, as at the timings T4 and T8, the transmission signal level at the output terminal is the low level output voltage Vol1. At a timing T12, as at the timings T5 and T6, the transmission signal level at the output terminal is the low level output voltage Vol2.

In this conventional output buffer circuit 1, described above, the transmission signal level at the output terminal is the output voltage Voh1 or the output voltage Voll only during a certain prefixed time corresponding to one clock period at the time of transition of the data signal and is the output voltage Voh2 or the output voltage Vol2 during . the time of the other clock periods. It becomes possible in this manner to apply pre-emphasis distortion to the logic amplitude at the outset only during the preset time, as the data signal undergoes a transition, to generate a transmission signal of a multi-level waveform to output the resulting signal to the transmission line 2 to prevent the waveform of the received signal at the receiving input unit from becoming dull against losses of the high frequency components on the transmission line 2. On the other hand, the output impedance of the output buffer circuit 1 is matched to the characteristic impedance of the transmission line 2 to prevent re-reflection at the transmission end as the reflection at the receiving end of the transmission line 2 to prevent garbled codes ascribable to multiple reflection from being produced.

SUMMARY OF THE DISCLOSURE

However, in the above-described conventional output buffer circuit 1, one of the two P-type output stage transistors 181 and 191 in the buffers 18 and 19 is necessarily on, with one of the two N- type output stage transistors 182 and 192 being necessarily on, at the timings T2 toT3, T5 to T6, T10 and T12, shown in Fig.5, when the data signal does not undergo any transition. For this reason, the short-circuit current flows from the power supply voltage Vd to the ground, through the output stage transistors of the buffers 18 and 19 and the output terminal, at all times during the clock periods when the data signal does not undergo transitions to render it difficult to lower the power consumption.

Accordingly, it is an object of the present invention to provide an output buffer circuit in which the power consumption may be reduced.

The above object is attained by an output buffer circuit, in accordance with one aspect of the present invention, which applies pre-emphasis distortion to the logic amplitude for a preset time at the time of transition of a data signal to generate a transmission signal of a multi-level waveform to output the generated transmission signal to a transmission line, and in which an output impedance is switched to either a power supply or a ground depending on the level of the data signal, and the output impedance is switched to a low value and to a high value depending on the time being within and outside the preset time respectively.

According to the present invention, the output impedance of the high value is matched to the characteristic impedance of the transmission line (2), while the output impedance of the low value is set depending on the pre-emphasis distortion and an output load.

The output buffer circuit, in accordance with another aspect of the present invention, further includes a delay circuit (12) for delaying the data signal or an inverted signal thereof by the preset time, a buffer (13) for buffering the data signal with an output impedance of the high value to output the buffered data signal to an output terminal, and a three-state buffer (14/15) which is controlled responsive to an output of the delay circuit and the data signal, is activated within the preset time for buffering the data signal to output the buffered signal to the output terminal, and is de-activated outside the constant time so as to be turned off.

The three-state buffer, in the output buffer circuit (1) in accordance with another aspect of the present invention, may well be controlled responsive to the coincidence or non-coincidence of an output of the delay circuit to logic value of the data signal.

The three-state buffer (14) in the output buffer circuit (1) in accordance with another aspect of the present invention, may also include two P-type output stage transistors (141, 142), connected across a power supply and the output terminal in series therewith and adapted for receiving a delayed signal of the data signal from the delay circuit (12) and an inverted signal of the data signal from gate electrodes respectively, and two N-type output stage transistors (143, 144), connected across the output terminal and the ground in series therewith and adapted for receiving the delayed signal and the inverted signal from gate electrodes respectively.

The three-state buffer (15), in the output buffer circuit (1) in accordance with another aspect of the present invention, may also include a two-input NAND gate (151) and a two-input NOR gate(152) for receiving an inverted delayed signal, obtained on delaying and inverting the data signal, and the data signal, respectively, a P-type output stage transistor (153) connected across a power supply, and adapted for receiving an output of the two-input NAND gate from its gate electrode, and an N-type output stage transistor (154) connected across the output terminal and the ground, and adapted for receiving an output of the two-input NOR gate from its gate electrode.

The output buffer circuit (1), in accordance with another aspect of the present invention, may also include a delay circuit (12) for delaying the data signal or an inverted signal thereof by the preset time, a three-state buffer (14/15) which is controlled responsive to an output of the delay circuit and the data signal, is activated outside the delay time for buffering the data signal to output the buffered signal to the output terminal, and is de-activated outside the delay time so as to be turned off.

The delay circuit (12), in the output buffer circuit (1) according to the present invention, is preferably so adapted to delay the signal a preset time shorter than the sum of the propagation time of the transmission signal and the propagation time of a reflection signal thereof.

The delay circuit (12), in the output buffer circuit (1) according to the present invention, is preferably so adapted to delay the signal a preset time corresponding to one clock period.

Still other objects and advantages of the present invention will become readily apparent to those skilled in this art from the following detailed description in conjunction with the accompanying drawings wherein only the preferred embodiments of the invention are shown and described, simply by way of illustration of the best mode contemplated of carrying out this invention. As will be realized, the invention is capable of other and different embodiments, and its several details are capable of modifications in various obvious respects, all without departing from the invention. Accordingly, the drawing and description are to be regarded as illustrative in nature, and not as restrictive.

BRIEF DESCRPTION OF THE DRWINGS

Fig.1 is a circuit diagram showing a configuration of the output buffer circuit according to a first embodiment of the present invention.
Fig.2 is a timing diagram showing a typical operation of the output buffer circuit 1 shown in Fig.1.
Fig.3 is a circuit diagram showing a configuration of the output buffer circuit according to a second embodiment of the present invention.
Fig.4 is a circuit diagram showing an illustrative configuration of a conventional output buffer circuit.

Fig.5 is a timing diagram showing a typical operation of the output buffer circuit 1 shown in Fig.4.

## PREFERRED EMBODIMENTS OF THE INVENTION

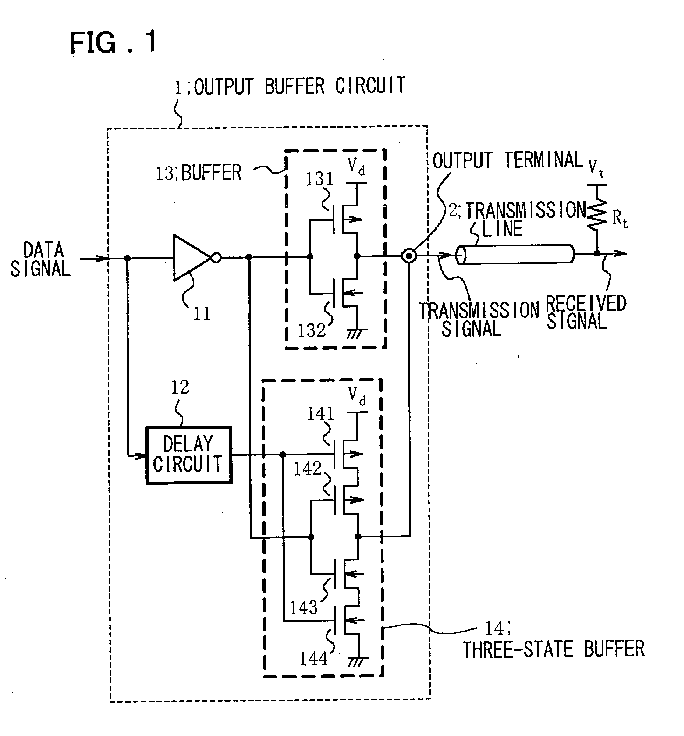

Referring to the drawings, the preferred embodiments of present invention are now explained in detail. Fig.1 depicts a circuit diagram showing a configuration of an output buffer circuit according to a first embodiment of the present invention. Referring to Fig.1, an output buffer circuit 1 according to the present embodiment includes an inverter 11, operating under the power supply voltage Vd, a delay circuit 12, a buffer 13 and a three-state buffer 14. The output buffer circuit 1 drives an transmission end of a transmission line 2 connected to an output terminal and outputs a transmission signal. The receiving end of the transmission line 2 is terminated by a terminal resistor Rt and a terminal voltage Vt and is matched to the characteristic impedance of the transmission line 2.

The inverter 11 is supplied from outside with a data signal, generated in synchronism with a clock signal, in a same manner as that described as a conventional technique with reference to Fig.4. The inverter 11 inverts the received data signal to output an inverted signal of the data signal.

The delay circuit 12 is supplied from outside with the data signal. In the present embodiment, by delay circuit 12 delays the data signal a preset time corresponding to one clock, in synchronism with the clock signal, to output the delayed signal of the data signal. Meanwhile, an inverted signal of the delayed signal becomes the inverted delayed signal of the external input signal, as explained in connection with Fig.4.

The buffer 13 receives an inverted signal of the data signal from the inverter 11 to output a buffered data signal to the output terminal. This buffer 3 includes a P-type output stage transistor 131 and an N-type output stage transistor 132, performing a complementary operation. The P-type output stage transistor 131 and the N-type output stage transistor 132 have an approximately equal on-resistance Ra, such that the output resistance of the buffer 13 is equivalent to the on-resistance Ra both at the time of outputting the high level and at the time of outputting the low level, and is matched to the characteristic impedance of the transmission line 2.

The three-state buffer 14 is connected to the output terminal in parallel with the buffer 13 and receives the inverted signal and the delayed signal of the data signal output from the inverter 11 and the delay circuit 12, respectively, and is controlled responsive to the data signal and the delayed signal thereof in such a manner that the three-state buffer is activated within a preset time, as the data signal undergoes a transition, to buffer and output the data signal to the output terminal. The three-state buffer 14 then is deactivated during the time outside the preset time, and is turned off. The three-state buffer 14 includes two P-type output stage transistors 141 and 142, which are connected in series across the power supply and the output terminal and have gate electrodes for receiving the inverted signal and the delayed signal of the data signal, and two N-type output stage transistors 143 and 144, which are connected in series across the output terminal and the ground and have gate electrodes for receiving the inverted signal and the delayed signal of the data signal. The P-type output stage transistors 141 and 142 and the N-type output stage transistors 143 and 144 have an approximately equal series on-resistance Rb, such that the output resistance of the three-buffer 14 is equivalent to the series on-resistance Rb and is set responsive to the pre-emphasis distortion and the output load. In the deactivated state, the output resistance of the three-buffer 14 becomes the high impedance in the off-state.

The output impedance Zout of the output buffer circuit 1, composed of the buffer 13 and the three-state buffer 14, as seen from the output terminal, is equal to the combined parallel resistance of the output resistances of the buffer 13 and the three-state buffer 14, and is formed by switching to the power supply or to the ground depending on the data signal level. Moreover, when the three-state buffer 14 is activated, the output impedance Zout of the output buffer circuit 1 is of the low value equivalent to the combined parallel resistance of the on-resistance Ra and the series on-resistance Rb, that is $RaRb/(Ra+Rb)$, and is set depending on the pre-emphasis distortion and the output load. On de-activation of the three-state buffer 14, the output impedance is of a high value equivalent to the on-resistance Ra and is matched to the characteristic impedance of the transmission line 2,

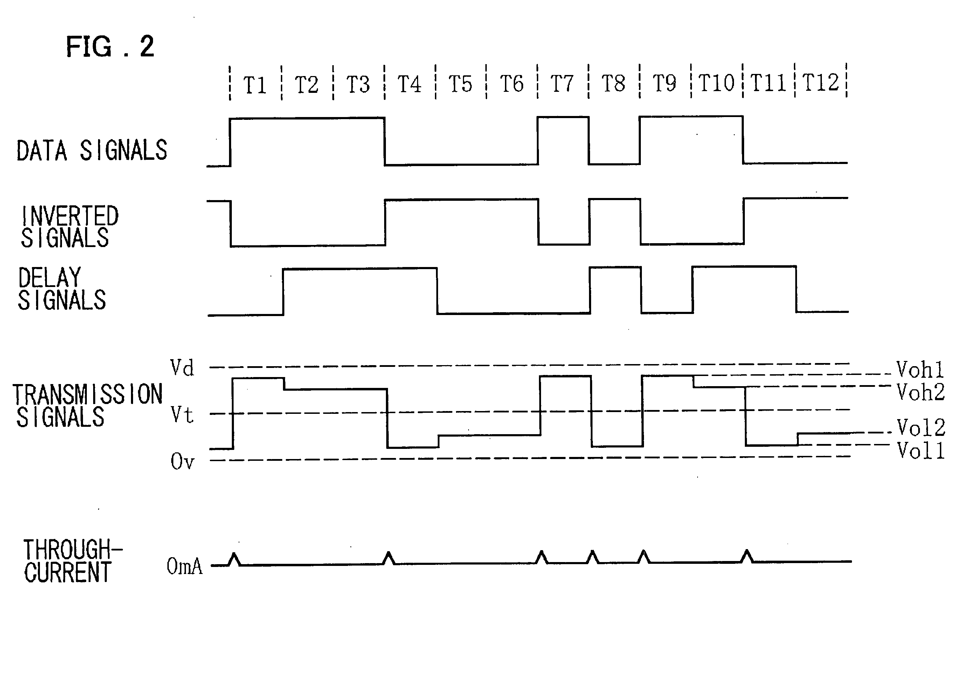

Fig.2 is a timing diagram showing a typical operation of the output buffer circuit 1 of the present embodiment. Referring to Figs.1 and 2, the operation of the present embodiment of the output buffer circuit 1 is explained.

First, at a timing T1, the data signal undergoes a transition from a low level to a high level, a delayed signal of the data signal is at a low level, and the P-type output stage transistors 131, 141 and 142 of the buffer 13 and the three-state buffer 14 are turned on, with the other output stage transistors being in the off-state. Thus, the circuit configuration is such that the power supply voltage Vd and the terminal voltage Vt are applied to the output terminal via on-resistances Ra and series on-resistance Rb of the P-type output stage transistors 131, 141 and 142 and the terminal resistance Rt, with the transmission signal level at the output terminal being, by Kirchhoff's law, the following high level output voltage Voh1 (the high level output voltage subjected to pre-emphasis):

$$Voh1 = Vt + (Vd-Vt)(Rb+Ra)Rt/(RaRb+RaRt+RtRb).$$

At timings T2 and T3, the data signal and the delayed signal are both at the high level, and the P-type output stage transistor 131 of the buffer 13 and the P-type output stage transistor 142 and the N-type output stage transistor 144 of the three-state buffer 14 are turned on, with the other output stage transistors being in the off-state. Thus, the circuit configuration is such that the power supply voltage Vd and the terminal voltage Vt are applied to the output terminal via on-resistance Ra of the P-type output stage transistor 131 and the terminal resistance Rt, with the transmission signal level at the output terminal being, by Kirchhoff's law, the following high level output voltage Voh2 (the high level output voltage subjected to de-emphasis):

$$Voh2 = (VtRa+VdRt)/(Ra+Rt).$$

At a beginning of a time period T4, the data signal undergoes a transition from a high level to a low level, the delayed signal of the data signal is at a high level, and the N-type output stage transistor 132 of the buffer 13, and the N-type output stage transistor 143 and 144 of the three-state buffer 14 are turned on, with the other output stage transistors being off. Thus, the circuit configuration is such that the grounding voltage 0V and the terminal voltage Vt are applied to the output terminal through the on-resistances Ra and the series resistance Rb of the N-type output stage transistors 132, 143 and 144 and the terminal resistance Rt, so that the transmission signal level at the output terminal is, by Kirchhoff's law, the following low level output voltage Vol1 (the low level output voltage subjected to pre-emphasis):

$$Vol1 = Vt-Vt(Ra+Rb)Rt/(RaRb+RaRt+RtRb).$$

At timings T5 and T6, the data signal and the delayed signal are both at a low level, and the N-type output stage transistor 132 of the buffer 13 and the N-type output stage transistor 143 and the P-type output stage transistor 141 of the three-state buffer 14 are turned on, with the other output stage transistors being off. Thus, the circuit configuration is such that the ground voltage 0V and the terminal voltage Vt are applied to the output terminal through the on-resistance Ra and the terminal resistance Rt of the N-type output stage transistor 132. Thus, the circuit state is such that the transmission signal level at the output terminal is, by Kirchhoff's law, the following low level output voltage Vol2(the low level output voltage subjected to de-emphasis):

$$Vol2 = VtRa/(Ra+Rb).$$

In similar manner, at timing T7, as at the timing T1, the transmission signal level at the output terminal is the high level output voltage Voh1. At timing T8, as at a timing T4, the transmission signal level at the output terminal is the low level output voltage Vol1. At a timing T9, as at the timings T1 and T7, the transmission signal level at the output terminal is the high level output voltage Voh1. At timing T10, as at the timing T2, the transmission signal level at the output terminal is the high level output voltage Voh2. At a timing T11, as at the timings T4 and T8, the transmission signal level at the output terminal is the low level output voltage Vol1. At a timing T12, as at the timings T5 and T6, the transmission signal level at the output terminal is the low level output voltage Vol2.

In the output buffer circuit 1 according to the present embodiment, the transmission signal level at the output terminal takes the high level output voltage Voh1 or the low level output voltage Vol1, only during a preset time corresponding to one clock period when the data signal undergoes a transition, while becoming equal to the high level output voltage Voh2 or the low level output voltage Vo12, during the other clock periods, by the changes in a divided voltage, which is based only on the impedance ratio between the terminal resistance and the output resistance through the transmission line. It becomes possible in this manner to apply pre-emphasis distortion to the logic amplitude at the outset only during the preset time as the data signal undergoes transitions, to generate a transmission signal of a multi-level waveform to output the resulting signal to the transmission line 2 to prevent the waveform of a received signal at the receiving input unit from becoming dull against the loss of the high frequency components on the transmission line 2.

On the other hand, the output buffer circuit 1 lacks in the combination in which the P-type output stage transistor 131 in the buffer 13 or the P-type output stage transistors 141 and 142 in the three-state buffer 14 are turned on and the N-type output stage transistor 132 in the buffer 13 or the N-type output stage transistors 143 and 144 in the three-state buffer 14 are turned on, such that the output impedance is switched to the power supply or to the ground in dependence upon whether the time is inside or outside the preset time when the data signal is undergoing transitions. Thus, in the present embodiment, in a manner different from the case of the conventional output buffer circuit 1 shown in Fig.4, the short circuit-current does not flow from the power supply voltage Vd to the ground through the output stage transistors in the buffer 13 and the three-state buffer 14 and an output terminal, even at the timings T2 to T3, T5 to T6, T10 and T12 during which the data signal does not change, as shown in Fig.2, thus decreasing the power consumption of the output buffer circuit.

Moreover, in the output buffer circuit 1 according to the present embodiment, the output impedance can be set so as to be lower than the characteristic impedance within the preset time, at the time of transition of the data signal, thereby enlarging the driving capability to expedite the operation as compared to that in the case of the conventional output buffer circuit of Fig.4.

Moreover, the low value of the output impedance can be set depending on the pre-emphasis distortion and the output load, thus increasing the degree of freedom in designing.

In the output buffer circuit 1 according to present embodiment, the output impedance becomes lower than that of the transmission line 2 only during the preset time of one clock period in which the data signal undergoes a transition, thus giving rise to impedance non-matching. However, by terminating the transmission line 2 at the receiving end to suppress the reflection, re-reflection at the transmission end of the transmission line 2 is suppressed to prevent the generation of garbled codes which is ascribable to multiple reflection, as in the conventional output buffer circuit 1 shown in Fig. 4.

In the output buffer circuit according to the present embodiment, the delay circuit 12 is arranged to cause signal delay by a preset time corresponding to one clock period in synchronism with the clock signal. However, such a modification is possible in which the delay circuit 12 causes signal delay by a preset time shorter than the sum of the propagation time of the transmission signal and that of the reflection signal thereof. In this modification, equivalent effects may be achieved. Moreover, even if reflection occurs due to impedance mismatching at the receiving end of the transmission line 2, the output impedance is switched to a high value for the reflection signal which is propagated from the receiving end to suppress re-reflection at the transmitting end by impedance matching at the transmission end to prevent the occurrence of garbled codes due to multiple reflection as in the case of the conventional output buffer circuit.

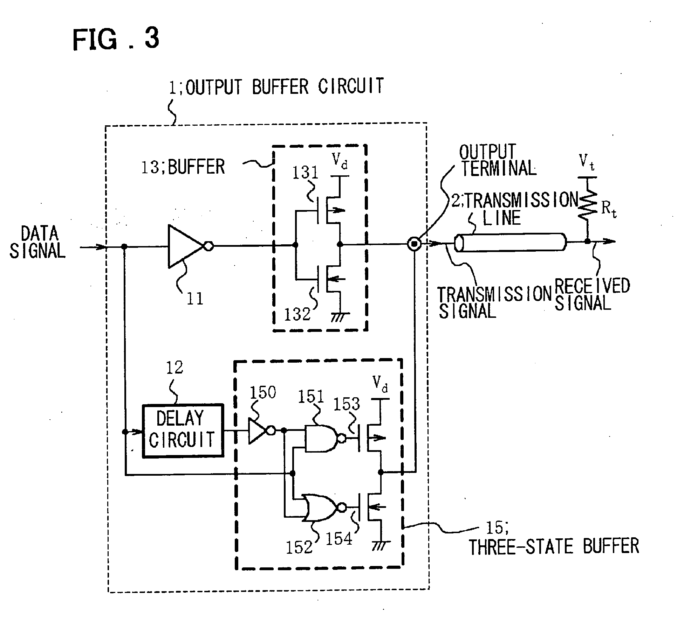

Fig.3 is a circuit diagram showing a configuration of the output buffer circuit according to a second embodiment of the present invention. The output buffer circuit 1 according to the second embodiment of the present invention, includes an inverter 11, a delay circuit 12, a buffer 13 and a three-state buffer 15. As compared to the output buffer circuit 1 of the first embodiment, shown in Fig.1, the blocks of the inverter 11, delay circuit 12 and the buffer 13 are the same as those of the output buffer circuit 1 of the first embodiment, shown in Fig.1, so that redundant explanation is omitted and the three-state buffer 15 is hereinafter explained.

The three-state buffer 15 is connected to the output terminal in parallel with the buffer 13 and, similarly to the three-state buffer 14 of the first embodiment of Fig.1, is controlled depending on the data signal and the delayed version thereof, and is activated within the preset time during which the data signal undergoes a transition. The data signal is buffered and output to the output terminal, while being deactivated outside the preset time and turned off.

In the present embodiment, this three-state buffer 15 is made up by an inverter 150, a two-input NAND gate 151, a two-input NOR gate 152, a P-type output stage transistor 153 and an N-type output stage transistor 154.

The inverter 150 receives a delayed signal of the data signal output from the delay circuit 12 and inverts the received delayed signal to deliver the inverted delayed signal of the data signal to the two-input NAND gate 151 and to the two-input NOR gate 152.

The two-input NAND gate 151 and the two-input NOR gate 152 receive the data signal and the inverted delayed signal thereof. The P-type output stage transistor 153 is connected across the power supply Vd and the output terminal and has its gate electrode connected to the output of the two-input NAND gate 151, while the N-type output stage transistor 154 is connected across the output terminal and a ground and has its gate electrode connected to the output of the two-input NOR gate 152.

The P-type output stage transistor 153 and the N-type output stage transistor 154 have an approximately equal on-resistance Rb, such that the output resistance of the three-state buffer 15 in the activated state is equivalent to the on-resistance Rb both at the time of outputting the high level and at the time of outputting the low level, while becoming the high impedance in the off-state, in the deactivated state of the buffer.

The output impedance Zout of the output buffer circuit 1, as seen from the output terminal, resulting from the parallel connection of the buffer 13 and the three-state buffer 15, is equivalent to the parallel combined resistance of the output resistances of the buffer 13 and the three-state buffer 15, and is of a low value on activation equivalent to the parallel combine resistance RaRb/(Ra+Rb) of the on-resistances Ra and Rb, while being of a high value on de-activation corresponding to the on-resistance Ra, for matching to the characteristic impedance of the transmission line 2.

The output buffer circuit 1 according to the present embodiment, operates as is in the case of the output buffer circuit 1 of the first embodiment, shown in Fig.1. Although redundant explanation is not made, it is apparent on comparison with the output buffer circuit 1 of the first embodiment, shown in Fig.1, that the output buffer circuit 1 of the present embodiment is more favorable in the space taken up by the circuit in case the output stage is not the series connection of the P-type output stage transistor and the N-type output stage transistor so that an output impedance of a lower value is to be set.

It has been explained that the output buffer circuit 1 of the above-described first and second embodiments and the modification is provided with the buffer 13 and with the three-state buffer 14 or 15. As a further modification, such a configuration is possible which is comprised of a three-state buffer controlled in association with an output of a delay circuit and a data signal, activated within a preset time, buffering and outputting the data signal to an output buffer, and which is de-activated outside the preset time so as to be turned off, and another three-state buffer controlled in association with an output of a delay circuit and a data signal, activated outside a preset time, buffering and outputting the data signal to an output buffer, and which is de-activated within the preset time so as to be turned off. With this modification, the same or equivalent effect as that of the aforementioned embodiment may well be attained.

The meritorious effects of the present invention are summarized as follows.

With the output buffer circuit of the present invention, described above, the three-state buffer is activated or de-activated, in controlled manner, in dependence upon whether the time is inside or outside the preset time when the data signal is undergoing a transition, the circuit is switched to the power supply or to the ground, in dependence upon the data signal level, and the output impedance is switched to a low value or to a high value, so that the circuit operates for applying the pre-emphasis in the same manner as the conventional output buffer circuit. On the other hand, no short circuit-current flows from the power supply Vd to the ground, through the output stage transistor and the output terminal, so that the power consumption of the output buffer circuit may be reduced.

Moreover, the output impedance may be set to a value lower than that of the transmission line, within a preset time during a transition of the data signal, the driving ability may be enlarged, and the circuit operation may be expedited than in the conventional output buffer circuit. Additionally, the low value of the output impedance may be set depending on the pre-emphasis distortion and the output load, while the degree of freedom in designing may be enhanced.

It should be noted that other objects, features and aspects of the present invention will become apparent in the entire disclosure and that modifications may be done without departing the gist and scope of the present invention as disclosed herein and claimed as appended herewith.

Also it should be noted that any combination of the disclosed and/or claimed elements, matters and/or items may fall under the modifications aforementioned.

**Claims**

1. An output buffer circuit applying pre-emphasis distortion to a logic amplitude of a data signal for a preset time when the data signal undergoes a transition to generate a transmission signal of a multi-level waveform and outputting the generated transmission signal to a transmission line, wherein an output impedance is switched to a power supply or to a ground depending on the level of the data signal; and wherein the output impedance is switched to a low value or to a high value depending on the time being within or outside the preset time.

2. The output buffer circuit as defined in claim 1, wherein the output impedance of the high value is matched to a characteristic impedance of the transmission line; and
   wherein the output impedance of the low value is set depending on the pre-emphasis distortion and an output load.

3. The output buffer circuit as defined in claim 1 or 2, comprising
   a delay circuit (12) for delaying the data signal or an inverted signal thereof by the preset time;
   a buffer (13) for buffering said data signal with an output impedance of said high value to output the buffered data signal to an output terminal; and
   a three-state buffer (14 /15) controlled responsive to an output of said delay circuit and said data signal, said three-state buffer being activated within said preset time for buffering said data signal to output the buffered signal to said output terminal, and being de-activated outside said preset time so as to be turned off.

4. The output buffer circuit as defined in claim 3, wherein said three-state buffer is controlled responsive to the coincidence or non-coincidence of an output of said delay circuit with logic value of said data signal.

5. The output buffer circuit as defined in claim 3 or 4, wherein said three-state buffer includes:

   two P-type output stage transistors (141, 142), connected across a power supply and said output terminal in series therewith, and having gate electrodes for receiving a delayed signal of said data signal and an inverted signal of said data signal respectively; and
   two N-type output stage transistors (143, 144), connected across said output terminal and the ground in series therewith, and having gate electrodes for receiving said delayed signal and said inverted signal respectively.

6. The output buffer circuit as defined in claim 3 or 4, wherein said three-state buffer includes:

   a two-input NAND gate (151) and a two-input NOR gate (152), each receiving an inverted delayed signal, obtained on delaying and inverting said data signal, and said data signal;
   a P-type output stage transistor (153), connected across a power supply, and having a gate electrode connected to an output of said two-input NAND gate; and
   an N-type output stage transistor (154), connected across said output terminal and the ground, and having a gate electrode connected to an output of said two-input NOR gate.

7. The output buffer circuit as defined in claim 1 or 2, comprising:

a delay circuit (12) receiving said data signal or an inverted signal thereof and delaying the received signal by said preset time; and a three-state buffer (14 /15) controlled responsive to an output signal of said delay circuit and said data signal, said three-state buffer being activated during the time outside said preset time to buffer said data signal to output the buffered signal to said output terminal, and being de-activated during the time within said preset time so as to be turned off.

8. The output buffer circuit as defined in any one of claims 3,4,5,6 and 7, wherein said delay circuit (12) delays the signal a preset time shorter than the sum of a propagation time of said transmission signal and a propagation time of a reflection signal thereof.

9. The output buffer circuit as defined in any one of claims 3,4,5,6 and 7, wherein said delay circuit (12) delays the data signal a preset time corresponding to one clock period.

# FIG . 1

1;OUTPUT BUFFER CIRCUIT

13;BUFFER

131 $V_d$

OUTPUT TERMINAL $V_t$

2;TRANSMISSION LINE $R_t$

DATA SIGNAL

11

132

12

DELAY CIRCUIT

141 $V_d$

142

143

144

14;
THREE-STATE BUFFER

TRANSMISSION SIGNAL

RECEIVED SIGNAL

# FIG. 2

| | T1 | T2 | T3 | T4 | T5 | T6 | T7 | T8 | T9 | T10 | T11 | T12 |

DATA SIGNALS

INVERTED
SIGNALS

DELAY
SIGNALS

TRANSMISSION
SIGNALS

Vd
Vt
0v

Voh1
Voh2
Vol2
Vol1

THROUGH-
CURRENT

0mA

EP 1 359 668 A1

# FIG . 3

FIG . 4

1; OUTPUT BUFFER CIRCUIT

18; BUFFER

181

$V_d$

OUTPUT TERMINAL $V_t$

2; TRANSMISSION LINE

$R_t$

DATA SIGNAL

11

182

19; BUFFER

191

$V_d$

TRANSMISSION SIGNAL

RECEIVED SIGNAL

INVERTED DELAYED SIGNAL OF DATA SIGNAL

17

192

13

## FIG. 5

| | T1 | T2 | T3 | T4 | T5 | T6 | T7 | T8 | T9 | T10 | T11 | T12 |

DATA SIGNAL

INVERTED DELAYED
SIGNAL OF
DATA SIGNAL

TRANSMISSION
SIGNAL

Vd — Voh1
Vt — Voh2
0v — Vol2 / Vol1

SHORT-CIRCUIT
CURRENT   0mA

EP 1 359 668 A1

## EUROPEAN SEARCH REPORT

European Patent Office

Application Number

EP 03 00 8573

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 189 399 A (NIPPON ELECTRIC CO) 20 March 2002 (2002-03-20) * abstract; figures 2,3 * --- | 1,2 | H03K17/16 H04L25/02 |
| X | US 5 751 161 A (BACH RANDALL ET AL) 12 May 1998 (1998-05-12) * column 5, line 30 - column 6, line 26; figures 1-5 * --- | 1,3 | |
| X | PATENT ABSTRACTS OF JAPAN vol. 1998, no. 08, 30 June 1998 (1998-06-30) & JP 10 079660 A (YAMAHA CORP), 24 March 1998 (1998-03-24) * abstract * --- | 1 | |
| X | PATENT ABSTRACTS OF JAPAN vol. 1999, no. 04, 30 April 1999 (1999-04-30) & JP 11 027132 A (HITACHI LTD), 29 January 1999 (1999-01-29) * abstract * ----- | 1 | TECHNICAL FIELDS SEARCHED (Int.Cl.7) H03K H04L |

The present search report has been drawn up for all claims

| Place of search | Date of completion of the search | Examiner |
|---|---|---|
| MUNICH | 1 September 2003 | Brown, J |

EP 1 359 668 A1

## ANNEX TO THE EUROPEAN SEARCH REPORT
## ON EUROPEAN PATENT APPLICATION NO.

EP 03 00 8573

This annex lists the patent family members relating to the patent documents cited in the above-mentioned European search report.
The members are as contained in the European Patent Office EDP file on
The European Patent Office is in no way liable for these particulars which are merely given for the purpose of information.

01-09-2003

| Patent document cited in search report | | | Publication date | Patent family member(s) | | Publication date |
|---|---|---|---|---|---|---|
| EP 1189399 | A | | 20-03-2002 | JP 2002094365 A | | 29-03-2002 |
| | | | | CN 1344079 A | | 10-04-2002 |
| | | | | EP 1189399 A2 | | 20-03-2002 |
| | | | | US 2002030517 A1 | | 14-03-2002 |
| US 5751161 | A | | 12-05-1998 | NONE | | |
| JP 10079660 | A | | 24-03-1998 | NONE | | |
| JP 11027132 | A | | 29-01-1999 | NONE | | |

EPO FORM P0459

For more details about this annex : see Official Journal of the European Patent Office, No. 12/82

16